# EUROPEAN PATENT SPECIFICATION

(11) **EP 0 653 121 B1**
(45) Date of publication and mention of the grant of the patent: **22.01.1997**
(21) Application number: 93917951.1
(22) Date of filing: 29.07.1993
(51) Int. Cl.: H03H 17/04, H03H 17/00

(54) **DIGITAL AUDIO SYNCHRONISER**
SYNCHRONISIERVORRICHTUNG FÜR DIGITALEN TON
SYNCHRONISEUR AUDIO NUMERIQUE

(30) Priority: 29.07.1992 GB 9216148
(43) Date of publication of application: 17.05.1995
(73) Proprietor: BRITISH BROADCASTING CORPORATION, London W1A 1AA (GB)
(72) Inventor: TRAVIS, Christopher, Julian, Tadworth Surrey KT20 6NP (GB)
(74) Representative: Abnett, Richard Charles
(86) International application number: GB9301612
(87) International publication number: WO9403973

(56) References cited:
- EP-A- 0 205 373
- EUROPEAN BROADCASTING UNION no. 183, October 1980, pages 222 - 226 GILCHRIST 'SAMPLING-RATE SYNCHRONISATION OF DIGITAL SOUND SIGNALS BY VARIABLE DELAY' cited in the application
- IEEE ACOUSTICS, SPEECH, AND SIGNAL PROCESSING MAGAZINE vol. 27, no. 1, February 1979, NEW YORK US pages 98 - 99 DON H. JOHNSON 'VARIABLE DIGITAL FILTERS HAVING A RECURSIVE STRUCTURE'
- IBM TECHNICAL DISCLOSURE BULLETIN. vol. 14, no. 8, January 1972, NEW YORK US pages 2280 - 2281 J. BESSEYRE 'DIGITAL FILTER SYNTHESIZING AN ALL-PASS NETWORK UTILIZING A SHIFT REGISTER'

## Description

### Background of the Invention

The invention relates to a digital audio synchroniser, which receives digital audio signals and synchronises them with a reference.

Digital audio signals are sampled signals. They are streams of numbers. The nominal sample rate is typically 48kHz. Signals that have exactly the same sample rate can be mixed or multiplexed relatively easily. Signals that have different sample rates can not. Even slight differences, such as with two independently-sourced signals of nominally the same sample rate, cause problems. Typical equipment behaviour with a signal that is, for example, one-tenth of a Hertz too fast is to omit one sample every ten seconds. With signals that are too slow, samples are repeated. Either way the "sample slips" are heard as small clicks in the audio. The normal way of avoiding these clicks is to frequency lock the sources to a common timing reference. This is not always possible. An alternative is to pass the unsynchronised signals via "synchronisers", to create versions which are locked to the reference.

The oldest type of digital audio synchroniser is the "buffer store" synchroniser, see e.g. Gilchrist, N.H.C., "Sampling-rate synchronisation of digital sound signals by variable delay", EBU Review - Technical, No. 183, October 1980. This applies a delay of perhaps several hundred sample periods to the signal, and accommodates fast or slow signals by allowing the delay steadily to increase or decrease. The samples are passed without modification until the delay reaches some maximum or minimum limit, when a large adjustment must take place. Disruptions of the audio are hence much less frequent than with normal sample slipping, but they are also much bigger. The main problem with buffer store synchronisers is the long and variable delay that they introduce.

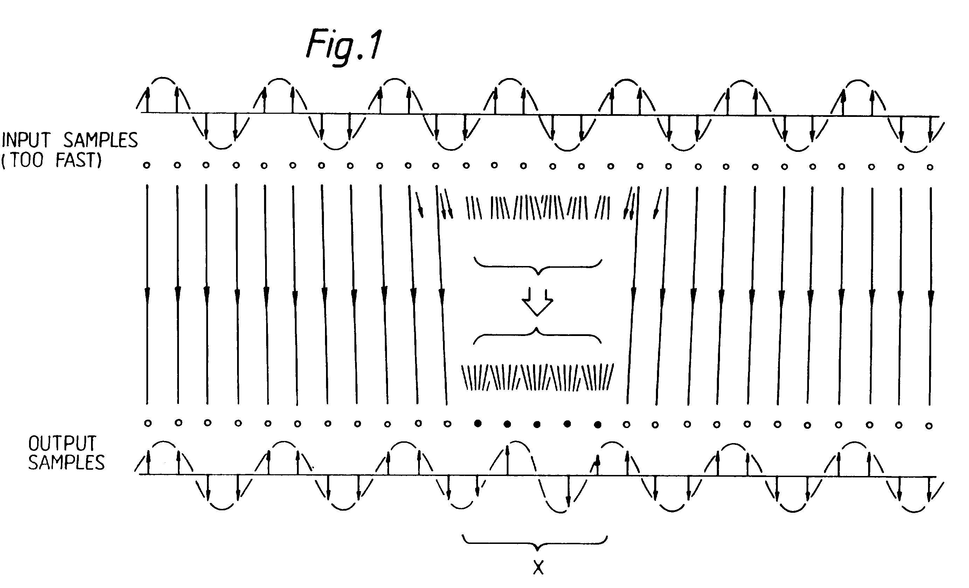

The most common type of digital audio synchroniser is the "interpolating" synchroniser. Like the "buffer store" type this lets most samples through unmodified, but when a slip is imminent it cycles through a processing sequence of the type illustrated in Figure 1. The sequence produces k calculated output samples but uses up k+1 (or k-1) input samples. Hence the hard slip is substituted by a more gradual adjustment of the delay. The aim is to create an output that is a time-warped version of the input. The duration and shape of the delay adjustment cycle are chosen to make it inaudible.

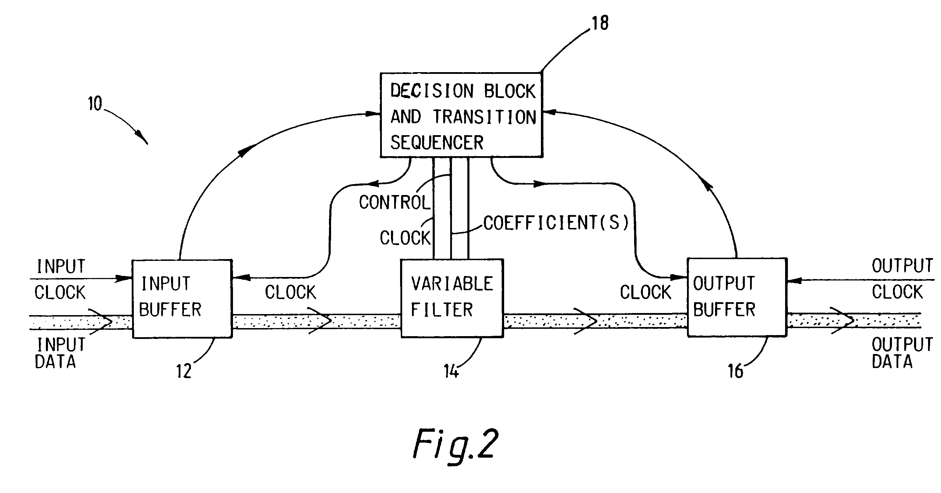

A block diagram of an interpolating synchroniser 10 is shown in Figure 2. An input FIFO (first in, first out) buffer 12 receives input data along with input (write) clock pulses. A variable filter 14 receives data from the input buffer 12 and passes data to an output FIFO buffer 16. The output buffer receives output (read) or reference clock pulses, derived from a frequency or phase reference, and supplies synchronised output data. The buffers 12, 16 and filter 14 are controlled by a decision block and transistion sequencer 18 which receives clock signals or pointer values from the buffers, and supplies read clock pulses to the input buffer and write clock pulses to the output buffer. It determines from the clock signals applied to it when a delay adjustment cycle needs to be executed. The variable filter 14 receives not only clock pulses but also control signals and coefficient values from the decision block and transition sequencer 18. The control line typically clears the internal storage of the filter. As such a synchroniser is well known, a more detailed description of its structure and operation is not deemed necessary. The principles of an interpolating synchroniser are described by Gilchrist, N.H.C., in "Sampling-Frequency Synchronisation with Minimal Delay" AES Journal, May 1988, pp 350-357. Reference may also be made to Lagadec, R., "A New Approach to Sampling Rate Synchronisation", 74th AES Convention, 8-11 October 1984, New York, preprint No. 2166.

From Figure 1, it will be seen that where the input and output samples are slightly out of synchronism, for the most part sample values are passed straight through the filter 14 from input to output. Over the region marked X, however, a delay adjustment cycle is executed in which each output sample is calculated as a weighted sum of a number of input samples. The sets of weighting coefficients are different for each sample.

It should be noted that the synchroniser can be arranged to operate with either the input buffer or the output buffer (but not both) omitted.

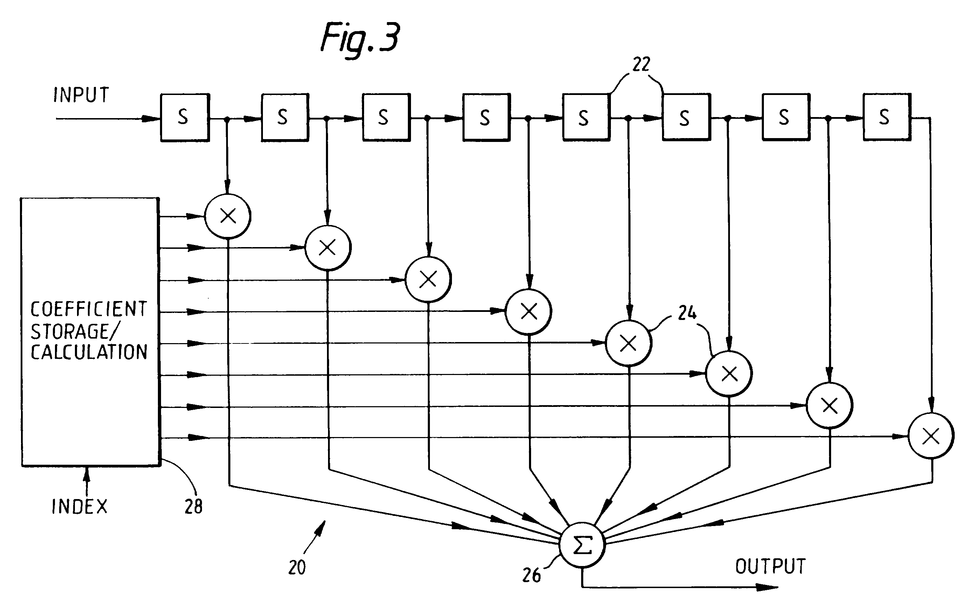

The target (or desired) response of the time-varying filters in interpolating synchronisers is that of a perfect delay. In other words, the target amplitude response is unity at all frequencies, and the target "group delay" response is the same at all frequencies. (During the adjustment sequence the delay is a varying non-integer number of sample periods). However, this target response can only ever be approximated. Every implementation inevitably has some amplitude and/or phase response errors. Simple filters have large errors, which are typically heard as amplitude modulation of the higher audio frequencies. For the errors to be acceptably small, a fairly complex filter must be used. One possible implementation is shown in Figure 3. It has eight multiplications and additions per sample period, and requires eight read/write registers, and storage for at least 64 filter coefficients. The average delay through this filter is 4½ sample periods. The filter 20 of Figure 3 is basically of the form of a transversal filter with a series of delays 22 each formed by a read/write storage register which serve to delay its input by one sample period. The output of each delay 22 is applied to a respective multiplier 24, and the outputs of the multipliers are summed in an adder 26. The multiplier coefficients are supplied from a coefficient store or calculator 28 which is within the circuit 18 of Figure 1.

### SUMMARY OF THE INVENTION

The invention in its various aspects is defined in the independent claims below, to which reference should now be made. Advantageous features are set forth in the appendant claims.

Preferred embodiments of the invention and more particularly of the variable digital filter are given by way of example below. The filters are each a substantially all-pass infinite-impulse-response (IIR) filter, of recursive form using feedback. They are found to give subjectively good performance, despite introducing a significant frequency dependence into the group delay. Furthermore they are relatively easy to implement and have relatively low average delays.

### Brief Description of the Drawings

The invention will be described in more detail, by way of example, with reference to the accompanying drawings, in which:-
**Figure 1** (referred to above) is a timing diagram illustrating the principle of operation of an interpolating synchroniser;
**Figure 2** (referred to above) is a block schematic diagram of a basic interpolating synchroniser;
**Figure 3** (referred to above) shows the construction of a known variable filter which can be used in the synchroniser of Figure 2; and
**Figures 4, 5, 6 and 7** are block diagrams of four variable filters which can be used in accordance with this invention in the synchroniser of Figure 2.

### Detailed Description of the Preferred Embodiments

A digital audio synchroniser embodying the invention is of the same form as shown in Figure 2, but uses a time-varying filter which is different from the filter shown in Figure 3. As previously, the filter is normally inactive and only comes into play when a delay adjustment cycle is required. Unlike the filter of Figure 3, however, the filters embodying the invention do not aim to create an output that is a time-warped version of the input. That is, the target response of the filter is not that of a perfect delay.

We have appreciated that the ear is relatively insensitive to group delay distortion, and that it is possible to take advantage of this psycho-acoustic observation to produce a filter which is more effective but less complex than the prior transversal-type filter.

In the filters to be described it can be shown that the delay adjustment is, by design, carried out at slightly different times for the different frequency components of the signal. One consequence is that rather than just being compressed or stretched, the waveform actually undergoes a change of shape.

As previously, target amplitude response is unity at all frequencies. However, the group delay constraints are relaxed in such a way that the response can be implemented both simply, and exactly, using "all-pass" filters. Amplitude response errors are avoided. All-pass digital filters are defined and described by Regalia, Mitra and Vaidyanathan "The Digital All-Pass Filter : A Versatile Signal Processing Building Block", Proc. IEEE, Vol. 76, No. 1, January 1988, pages 19-37. Reference may also be made to Mitra and Hirano, "Digital All-Pass Networks", IEEE Trans. Circuits and Systems, Vol. CAS-21, No. 5, September 1974, pages 688-700.

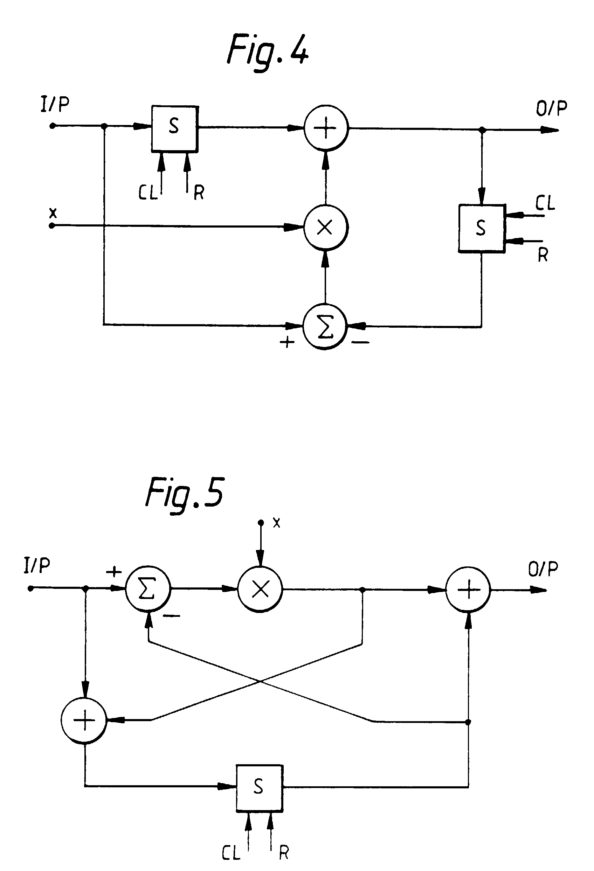

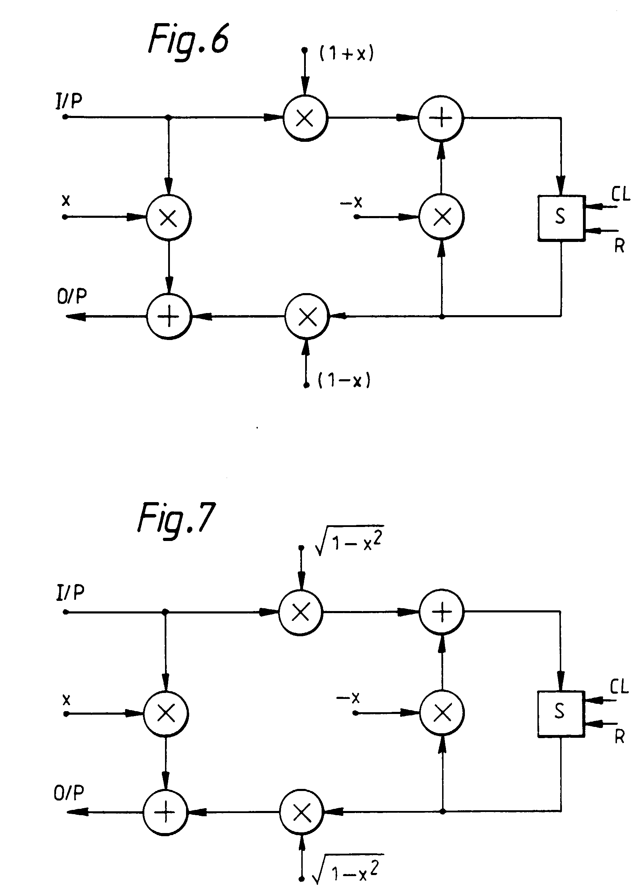

Four examples of filters in accordance with the invention will now be described with reference to Figures 4, 5, 6 and 7 respectively. Each filter is comprised of a selection of adders, combiners, multipliers, and one-sample storage registers shown in conventional form. The construction of the circuits will be so clearly apparent to the skilled man that a detailed description of each individual one of the circuits is not necessary. It will be noted that each circuit has an input designated I/P and an output designated O/P and includes at least one storage register S which receives clock pulses CL and a clear (reset) pulse R. The weighting coefficient is x, and is applied to the circuits of Figures 6 and 7 in more than one place in the form of different functions of x. Figure 6 requires x, -x, (1 + x) and (1 - x) and Figure 7, which is otherwise identical, requires x, -x, and the square root of (1 - x²).

Considering Figure 4, when the coefficient x is zero, the filter output is simply a delayed copy of its input. The delay is one sample period. When x is one (unity), it can be shown that the output is an undelayed copy of the input. To achieve the required smooth adjustment of delay, the value of x is changed smoothly between zero and one. This implementation has only one multiplication and two additions per sample period, and it requires only two read/write storage registers. No coefficient storage is needed. The average delay through this filter is half a sample period.

The filters are all chosen to be infinite-impluse-response (IIR) filters and are all recursive or recirculating in form, relying upon feedback. By contrast the filter of Figure 3 has a finite impulse response and no feedback. They are all substantially all-pass filters, though the filter of Figure 7 is not exactly all-pass because a square root operation is applied to one of the weighting coefficient inputs. This, in a digital system, introduces a degree of quantising as the square roots can not be accurately represented as finite precision numbers. Nevertheless we have found that the use of infinite impulse response filters based on a recursive form is advantageous. The recursive nature of the filter means that the group delay response is frequency dependent, which might be expected to produce a poor result. However, we have found that this is subjectively not the case.

The precise form of recursive filter to be used may depend upon the particular application, and the best form may need to be determined empirically. Different filter structures will be found to have different advantages and disadvantages. Indeed there may be benefit in using an adaptive structure that takes one form when the input is too fast and another form when it is too slow. All the filters shown are first-order all-pass filters. There may be some benefit in using higher order filters.

## Claims

1. A digital audio synchroniser comprising at least one buffer store (12,16) capable of being written to and read from at different respective rates in series with a substantially all-pass digital interpolating filter (14) which provides a variable delay, and control means (18) coupled to the buffer store (12,16) and the interpolating filter (14) and being responsive to timing signals present at the input and the output of the digital audio synchroniser such that when a "slip" is indicated by the input and output timing signals the control means (18) commands the interpolating filter (14) to execute a delay adjustment cycle, characterised in that the interpolating filter (14) is a recursive infinite-impulse-response filter.

2. A synchroniser according to claim 1, in which there are two buffer stores (12,16), one preceding (12) and one following (16) the interpolating filter (14).

3. The use for digital audio synchronisation of a digital audio synchroniser in accordance with claim 1 or 2.

4. A method of synchronising a digital audio signal with a timing reference, comprising applying the signal to a series circuit including at least one buffer store (12,16) capable of being written to and read from at different respective rates and a substantially all-pass digital interpolating filter (14) which provides a variable delay, and controlling the buffer store (12,16) and the interpolating filter (14) in dependence upon timing signals present at the input and the output of the digital audio synchroniser such that when a "slip" is detected the interpolating filter (14) executes a delay adjustment cycle, characterised in that the interpolating filter (14) has a recursive infinite-impulse-response function.

## Patentansprüche

1. Synchronisiervorrichtung für digitalen Ton, die aufweist: wenigstens einen Pufferspeicher (12, 16), in den mit jeweils unterschiedlichen Geschwindigkeiten geschrieben und von dem entsprechend gelesen werden kann, in Reihenschaltung mit einem digitalen Allpaß-Interpolationsfilter (14), der eine variable Verzögerung liefert, und Steuereinrichtungen (18), die mit dem Pufferspeicher (12, 16) und dem Interpolationsfilter (14) gekoppelt sind, und für die Taktsignale, die am Eingang und am Ausgang der Synchronisiervorrichtung für digitalen Ton vorhanden sind, verantwortlich sind, so daß, wenn durch die Eingangs- und Ausgangstaktsignale eine Verschiebung angezeigt wird, die Steuereinrichtungen (18) den Interpolationsfilter (14) anweisen, einen Verzögerungsabstimmzyklus auszuführen,
**dadurch gekennzeichnet**,
daß der Interpolationsfilter (14) ein rekursiver IIR-Filter (infinite-impulse-response = unbegrenztes Ansprechen auf einen Impuls) ist.

2. Synchronisiervorrichtung nach Anspruch 1,
in der es zwei Pufferspeicher (12, 16), einen vor (12) und einen folgend auf (16) den Interpolationsfilter (14) gibt.

3. Der Einsatz der Synchronisiervorrichtung für digitalen Ton nach Anspruch 1 oder 2 für die digitale Tonsynchronisation.

4. Ein Verfahren für das Synchronisieren eines digitalen Ton-signals mit einer Zeitreferenz, umfassend: das Anlegen des Signals an einen Reihenschaltkreis, der wenigstens einen Pufferspeicher (12, 16), in den mit jeweils unterschiedlichen Geschwindigkeiten geschrieben und von dem entsprechend gelesen werden kann, und einen wirklichen digitalen Allpaß-Interpolationsfilter (14), der eine variable Verzögerung liefert, aufweist, und das Ansteuern des Pufferspeichers (12, 16) und des Interpolationsfilters (14) in Abhängigkeit von Taktsignalen, die am Eingang und am Ausgang der Synchronisiervorrichtung für digitalen Ton vorhanden sind, so daß, wenn eine Verschiebung festgestellt wird, der Interpolationsfilter (14) einen Verzögerungsabstimmzyklus ausführt,
**dadurch gekennzeichnet**,
daß der Interpolationsfilter (14) eine rekursive IIR-Funktion (infinite-impulse-response = unbegrenztes Ansprechen auf einen Impuls) aufweist.

## Revendications

1. Synchroniseur audio numérique comprenant au moins une mémoire tampon (12, 16), capable d'être écrite et lue à des vitesses respectives différentes, en série avec un filtre numérique d'interpolation sensiblement passe tout (14) qui fournit un retard variable, et des moyens de commande (18) couplés à la mémoire tampon (12, 16) et au filtre d'interpolation (14), et étant sensibles aux signaux de cadencement présents à l'entrée et à la sortie du synchroniseur audio numérique, de façon que lorsqu'un "glissement" est indiqué par les signaux de cadencement d'entrée et de sortie, les moyens de commande (18) ordonnent au filtre d'interpolation (14) d'exécuter un cycle de réglage de retard, caractérisé en ce que le filtre d'interpolation (14) est un filtre récursif à réponse impulsionnelle infinie.

2. Synchroniseur selon la revendication 1, dans lequel il existe deux mémoires tampon (12, 16), l'une précédant (12), et l'autre suivant (16), le filtre d'interpolation

3. Utilisation pour une synchronisation audio numérique d'un synchroniseur audio numérique selon la revendication 1 ou 2.

4. Procédé de synchronisation d'un signal audio numérique avec une référence de temps, comprenant l'application du signal à un circuit en série, comportant au moins une mémoire tampon (12, 16) capable d'être écrite et lue à des vitesses respectives différentes, et un filtre numérique d'interpolation sensiblement passe tout (14) qui fournit un retard variable, et la commande de la mémoire tampon (12, 16) et du filtre d'interpolation (14) en fonction des signaux de cadencement présents à l'entrée et à la sortie du synchroniseur audio numérique, de façon que lorsqu'un "glissement" est détecté, le filtre d'interpolation (14) exécute un cycle de réglage de retard, caractérisé en ce que le filtre d'interpolation (14) a une fonction récursive à réponse impulsionnelle infinie.
